# EUROPEAN PATENT APPLICATION

(11) **EP 4 339 000 A1**
(43) Date of publication of application: **20.03.2024**
(21) Application number: 23196977.5
(22) Date of filing: 12.09.2023
(51) Int. Cl.: B60K 35/22

(54) **PANEL WITH ACTIVE LAYER**

(30) Priority: 13.09.2022 US 202263405975 P
(71) Applicant: Apple Inc., Cupertino CA 95014 (US)
(72) Inventor: KINGMAN, David E., Cupertino, 95014 (US); MASSCHELEIN, Peter F., Cupertino, 95014 (US); CONNOLLY, Paul M., Cupertino, 95014 (US)
(74) Representative: Barton, Russell Glen

(57) **Abstract**

A panel includes an outer layer and an inner layer. A mask layer is positioned between the outer layer and the inner layer. An active layer is positioned between the mask layer and the inner layer and adjacent to an outer edge of the panel. The active layer extends from the outer edge of the panel toward a central portion of the panel and includes an independently controllable active element configured to limit viewing of the mask layer.

## Description

### CROSS-REFERENCE TO RELATED APPLICATIONS

This application claims the benefit of United States Provisional Application No. 63/405,975, filed on September 13, 2022, the contents of which are hereby incorporated by reference in its entirety for all purposes.

### FIELD

The present disclosure relates generally to the field of panels coupled with a structure.

### BACKGROUND

A panel of a structure can be positioned in various locations on or around the structure and provide a surface through which the external environment can be viewed through the panel. A panel can include, for example, a transparent surface and can be positioned on various portions of the structure.

### SUMMARY

One aspect of the disclosure is a panel of a vehicle that includes an outer layer and an inner layer that is positioned closer to an interior surface of the vehicle than the outer layer. A mask layer is positioned between the outer layer and the inner layer. An active layer is positioned between the mask layer and the inner layer and adjacent to an outer edge of the panel. The active layer extends from the outer edge of the panel toward a central portion of the panel and includes a first independently controllable active element configured to limit viewing of the mask layer when viewed from a cabin of the vehicle.

Another aspect of the disclosure is a panel of a vehicle that includes an outer layer and an inner layer that is positioned closer to an interior surface of the vehicle than the outer layer. A mask layer is positioned between the outer layer and the inner layer, and an active layer is positioned between the mask layer and the inner layer. The active layer extends at least partially around a perimeter of the panel and from an outer edge of the panel toward a central portion of the panel and includes a first independently controllable active element. The first independently controllable active element is configured to have a high transmissivity state and a low transmissivity state based on a signal received from a sensor.

Yet another aspect of the disclosure is a vehicle window for limiting viewing of a mask layer. The vehicle window includes a central portion through which an external environment can be viewed through the vehicle window. An active layer extends around a perimeter of the vehicle window and from an outer edge of the vehicle window toward the central portion and includes an array of independently controllable active elements having a visual characteristic configured to be controlled in response to a signal.

### BRIEF DESCRIPTION OF THE DRAWINGS

FIG. 1 is an illustration of a cross-section of a panel of a vehicle.
FIG. 2 is an illustration of an active layer of the panel of FIG. 1.
FIG. 3A is an illustration of the active layer of the panel of FIG. 1 and a mask layer.
FIG. 3B is an illustration of a cross-section of a portion of the panel of FIG. 3A taken across B-B.
FIG. 4 is an illustration of the active layer of the panel of FIG. 1 in a first configuration.
FIG. 5 is an illustration of the active layer of the panel of FIG. 1 in an additional configuration.
FIG. 6 is schematic diagram of a controller.

### DETAILED DESCRIPTION

The disclosure herein relates to a panel of a vehicle that allows occupants of the vehicle to view the external environment through the panel. The panel may include various layers coupled together to create the panel. The panel may also include a mask layer that is configured to obscure an adhesive used to bond the panel to the vehicle, and the mask can typically be viewed by occupants within the vehicle. One of the layers may be an active layer that includes an array of independently controllable active elements that may be configured to have an opaque configuration and a transparent configuration.

In some implementations, the active layer may be configured to generate an opaque portion and a transparent portion, and the relative widths of the opaque portion and the transparent portion can be adjusted. In some embodiments, the width of the opaque portion is configured to limit visibility of the mask layer when viewed from within the vehicle.

The active layer may also be configured to change in response to a signal or a command. In some implementations, the width of the opaque portion is configured to change based on a brightness level of the external environment (e.g., the opaque portion may become wider as the brightness level increases). The opaque portion may also be configured to change its shape based on a sound. For example, the opaque portion may change its shape according to music playing in the vehicle. As another example, the opaque portion may change its shape and/or width based on a command from an occupant. In addition, the opaque portion may be configured to convey information to an occupant.

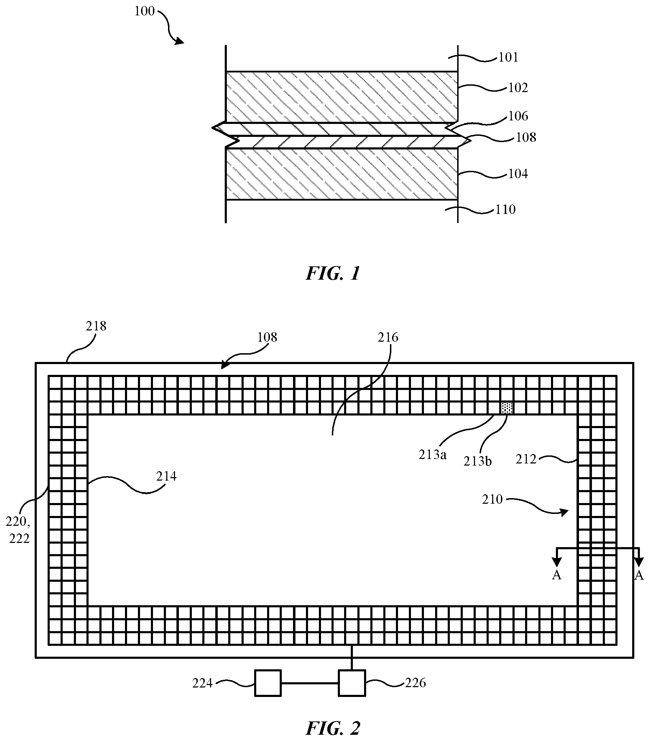

FIG. 1 is an illustration of a cross-section of a panel 100 of a vehicle taken across A-A of FIG. 2. In some implementations, the vehicle can be any type of vehicle including, but not limited to, gas or diesel-powered vehicles, electric vehicles, boats or other marine vehicles, aircraft (e.g., airplanes, helicopters, etc.), remote-controlled vehicles, etc. In some implementations, the vehicle is an autonomous vehicle. The vehicle may also include a cabin that is configured to hold one or more occupants. In some implementations, the panel 100 may be configured as a vehicle window The panel 100 may also be configured as a windscreen. In some implementations, the panel 100 may be configured as a roof of a vehicle. The panel 100 may also be configured as a sunroof or a moonroof of a vehicle. In some implementations, the panel 100 may be configured as a cover for headlights, brake lights, or any other type of light that may be used.

The panel 100 may be positioned in various locations on the vehicle. For example, the panel 100 may be positioned in a front portion, a rear portion, a top portion, a bottom portion, and/or in various locations around the sides or perimeter of the vehicle. In some implementations, the vehicle may include only one of the panel 100. In some implementations, the panel 100 may extend over multiple locations described. For example, the panel 100 may extend from the front portion to the rear portion of the vehicle, from one side to another side of the vehicle, from the top portion to the bottom portion of the vehicle, and/or combinations thereof. Accordingly, the panel 100 may be configured to provide a panoramic view of an external environment 101 located outside of the vehicle.

As shown, the panel 100 includes an outer layer 102 and an inner layer 104. The inner layer 104 may be positioned closer to an interior surface 110 of the vehicle than the outer layer 102. A mask layer 106 is positioned between the outer layer 102 and the inner layer 104. An active layer 108 is positioned between the mask layer 106 and the inner layer 104. The outer layer 102 and the inner layer 104 may be transparent (e.g., formed from a transparent material) to allow transmission of light through the panel 100. In some implementations, the outer layer 102 and the inner layer 104 may include glass. The outer layer 102 and the inner layer 104 may also include a transparent polymer (e.g., polycarbonate, acrylic, etc.). In some implementations, an intermediate layer is positioned between the inner layer 104 and the outer layer 102. The intermediate layer may also include a transparent polymer such as polyvinyl butyral ("PVB") and/or ethyl-vinyl acetate ("EVA"). The intermediate layer may be included to bond the other layers together to form a laminated panel. In some implementations, the mask layer 106 and the active layer 108 may be positioned on different sides of the intermediate layer. For example, the mask layer 106 may be positioned between the outer layer 102 and the intermediate layer, and the active layer 108 may be positioned between the intermediate layer and the inner layer 104. The mask layer 106 and the active layer 108 may also be positioned on the same side as the intermediate layer. For example, the mask layer 106 and the active layer 108 may be positioned between the outer layer 102 and the intermediate layer. The mask layer 106 and the active layer 108 may also be positioned between the intermediate layer and the inner layer 104.

The mask layer 106 may be opaque and may be configured to obscure a view of an adhesive used to secure the panel 100 to the vehicle when the mask layer 106 is viewed from outside the vehicle. In some embodiments, the mask layer 106 may be configured to obscure a view of an adhesive used to secure the active layer 108 to the panel 100 and/or the vehicle. In some implementations, the active layer 108 includes an additional adhesive that extends around the perimeter of the active layer 108 to secure components of the active layer 108 within the active layer 108. In such implementations, the mask layer 106 may also be used to obscure the additional adhesive. The mask layer 106 may be a coating applied to a surface of one of the layers of the panel 100 and may include a ceramic material that is adhered to the panel 100 via a heating process. The mask layer 106 may also include a solid band of ceramic material extending around a perimeter of the panel 100 from an outer edge of the panel 100 that gradually tapers to include distinct dots (e.g., frits) that extend from the solid band toward a central portion of the panel 100. In addition, the mask layer 106 may include additional and/or other materials such as paint, ink, adhesives, and/or combinations thereof. In some implementations, the mask layer 106 includes a black color and can be viewed from the interior of vehicle.

The active layer 108 may be configured to obscure the view of the mask layer 106 when viewed from the interior of the vehicle. The active layer 108 may also be configured to obscure the view of the adhesive used to secure the panel 100 to the vehicle. In some implementations, the active layer 108 may be configured to change the opacity of various portions of the active layer 108. The active layer 108 and its operation is further described with reference to FIGS. 2-5.

FIG. 2 is an illustration of the active layer 108 of the panel 100 of FIG. 1. The active layer 108 is positioned adjacent to an outer edge 220 of the panel 100 and extends at least partially around a perimeter of the panel 100 from the outer edge 220 toward a central portion 216 of the panel 100. The central portion 216 is defined by an inner edge 214 of the active layer 108. In implementations where the panel 100 is a vehicle window, the external environment 101 can be viewed through the central portion 216 of the vehicle window. The active layer 108 includes an array 210 of independently controllable active elements 212 that are configured to limit viewing of the mask layer 106 when viewed from a cabin of the vehicle. As shown, the inner edge of the array 210 is configured in a rectangular shape and defines the central portion 216 as having a rectangular shape. The inner edge of the array 210 can be configured in various shapes such as square, circular, oval, or an irregular shape to define the central portion 216 as having the same shape as the inner edge of the array 210. The outer edge 220 is also shown as having a rectangular shape and defines the outer shape of the array 210, but can be configured in various shapes (e.g., square, circular, oval, irregular, etc.) to define the outer shape of the array 210 accordingly. As shown, the outer edge 220 is coincident with an inner edge 222 of an interior trim 218 of the vehicle. In some implementations, the inner edge 222 overlaps the outer edge 220 such that the inner edge 222 obscures viewing of a portion of the array 210 when viewed from the cabin of the vehicle.

As shown, the independently controllable active elements 212 include a first independently controllable active element 213a and a second independently controllable active element 213b. The first independently controllable active element 213a and the second independently controllable active element 213b are each configured to have a transparent configuration (as indicated by the empty portion of the first independently controllable active element 213a) in which light can pass through such that objects in the external environment 101 can be viewed. In some implementations, the transparent configuration may include perfect transparency (e.g., 100% transmission of light through the first independently controllable active element 212). The first independently controllable active element 213a and the second independently controllable active element 213b are also configured to have an opaque configuration (as indicated by the filled portion of the independently controllable active element 213b) in which light is limited from passing through such that objects in the external environment 101 cannot be viewed. Complete blockage of light passing through the independently controllable active elements 212 is not required for the independently controllable active elements 212 to be in the opaque configuration (e.g., the opaque configuration is satisfied if an object in the external environment 101 cannot be viewed through, for example, the second independently controllable active element 213b). In some implementations, the independently controllable active elements 212 include a switchable polymer dispersed liquid crystal (e.g., PDLC) film. More specifically, the independently controllable active elements 212 may include liquid crystal microdroplets that are suspended in polymer and are configured to respond to voltage. When a voltage is applied to the independently controllable active elements 212 (e.g., the first independently controllable active element 213a, the second independently controllable active element 213b, or a combination thereof), the configuration changes from the transparent configuration to the opaque configuration (and vice versa). The independently controllable active elements 212 include an electrical component (e.g., an electrode) configured to direct electricity to the respective one of the independently controllable active elements 212 (e.g., the first independently controllable active element 213a, the second independently controllable active element 213b, etc.) to control its opacity. For example, when a voltage is applied to an electrode associated with the first independently controllable active element 213a, the first independently controllable active element 213a is configured to change from the opaque configuration to the transparent configuration (or vice versa). In some implementations, the opacity of the independently controllable active elements 212 may be changed based on a voltage level applied (e.g., a higher voltage level may induce a higher opacity level or transparency level, and a lower voltage level may induce a lower opacity level or transparency level).

The array 210 may include multiple independently controllable active elements 212 (e.g., a third independently controllable active element, a fourth independently controllable active element, etc.), and each of the independently controllable active elements 212 may have the same properties as those described with respect to the first independently controllable active element 213a and the second independently controllable active element 213b. Each of the independently controllable active elements 212 may also operate in the same manner as described with respect to the first independently controllable active element 213a and the second independently controllable active element 213b.

In an example implementation, voltage can be applied to single elements (e.g., the first independently controllable active element 213a), groups of elements (e.g., the first independently controllable active element 213a and the second independently controllable active element 213b), or the entire active layer 108 (e.g., all of the independently controllable active elements 212) to change a visual attribute of the active layer 108. Thus, the visual attribute of the first independently controllable active element 213a may be adjusted independently of the visual attribute of the second independently controllable active element 213b such that the visual attribute of the first independently controllable active element 213a and the visual attribute of the second independently controllable active element 213b are different.

Additional and/or other technologies may be implemented for the independently controllable active elements 212. For example, the independently controllable active elements 212 may include a guest-host liquid crystal (GHLC) film in which the liquid crystal matrix in which the liquid crystal microdroplets are suspended may include polymers, inorganic particles, dichroic dye, or a combination thereof. As another example, the independently controllable active elements 212 may include suspended particle devices (SPD) that include light-absorbing particles suspended in a liquid or film. When a voltage is applied to the SPD, the light-absorbing particles align to allow light to pass through. As an additional example, the independently controllable active elements 212 may include an electrochromic material that includes metal oxides configured to change opacity when a voltage is applied.

In the transparent configuration, the independently controllable active elements 212 may have a transmissivity of greater than or equal to 50% (e.g., the independently controllable active elements 212 may be configured to transmit at least 50% of visible light through the active layer 108 when in the transparent configuration). For example, the independently controllable active elements 212 may be configured to transmit 100% of visible light through the active layer 108 when in the transparent configuration. The independently controllable active elements 212 may also have a transmissivity of between 50% and 100% of visible light through the active layer 108 when in the transparent configuration. For example, when the independently controllable active elements 212 transmit between 50% and 100% of visible light through the active layer 108, the panel 100 may look as though it has a tint or a haze (e.g., objects in the external environment 101 viewed through the panel 100 may be seen clearly by an observer in the vehicle 100, but the objects may be darker than when viewed through the panel 100 with 100% transmissivity). In some implementations, when the independently controllable active elements 212 transmit between 50% and 100% of visible light through the active layer 108, the panel 100 may look as though it is translucent (e.g., objects in the external environment 101 viewed through the panel 100 may not be seen clearly by an observer in the vehicle 100).

In the opaque configuration, the independently controllable active elements 212 may have a transmissivity of between 0% and 50% (e.g., the independently controllable active elements 212 may be configured to transmit between 0% and 50% of visible light through the active layer 108 when in the opaque configuration). When in the opaque configuration, the independently controllable active elements 212 may also be configured to display a color. In some implementations, the independently controllable active elements 212 may be configured to display the same color when in the opaque configuration. The independently controllable active elements 212 may also be configured to display different colors when in the opaque configuration. For example, the first independently controllable active element 213a may be configured to display a red color and the second independently controllable active element 213b may be configured to display a blue color when in the opaque configuration. In some embodiments, the color of the independently controllable active elements 212 when in the opaque configuration approximately matches a color of the interior trim 218. For example, the interior trim 218 and the independently controllable active elements 212 in the opaque configuration may have red, green, and blue ("RGB") values and/or cyan, magenta, yellow, and black ("CMYK") values that are within ten percent, or twenty percent, or thirty percent, of each other. For example, a color of the interior trim 218 may have an RGB value of (135, 62, 35) and/or a CMYK value of (0, 54, 74, 47). To approximately match the color of the interior trim 218, the color of the independently controllable active elements 212 may include ranges of RGB values of (122-149, 56-68, 32-39) and CMYK values of (0, 49-59, 67-81, 42-52). Approximately matching the colors as described reduces a contrast in colors between the interior trim 218 of the vehicle and the panel 100 that would otherwise exist if the colors were not approximately matched. Reducing contrast in colors between the interior trim 218 of the vehicle and the panel 100 leads to a visually homogeneous appearance of the interior of the vehicle.

Arranged as described, the independently controllable active elements 212 are configured to have a low transmissivity state and a high transmissivity state. In the high transmissivity state, a higher amount of light transmission through the independently controllable active elements 212 is permitted as compared to an amount of light transmission permitted through the independently controllable active elements 212 in the low transmissivity state. For example, the first independently controllable active element 213a is in the high transmissivity state when in the transparent configuration, and the second independently controllable active element 213b is in the low transmissivity state when in the opaque configuration.

The independently controllable active elements 212 are shown as square elements arranged in a grid in FIG. 2, however the independently controllable active elements 212 can include various other shapes that can be arranged in other configurations. For example, the independently controllable active elements 212 may include irregular shapes that interface to define the central portion 216 as a round (e.g., circular, oval, etc.) portion.

A controller 226 is electrically coupled with the active layer 108 and a sensor 224, and is configured to generate a control signal based on a signal received from the sensor 224. The active layer 108 may operate in response to the control signal. For example, the independently controllable active elements 212 may change between the opaque configuration and the transparent configuration based on the control signal from the controller 226. Accordingly, the independently controllable active elements 212 have visual characteristics that are configured to change in response to the signal received from the sensor 224 (e.g., the independently controllable active elements 212 are configured to have a transparent configuration and an opaque configuration based on the signal received from the sensor 224).

The sensor 224 is configured to generate a signal in response to a sensed condition and provide the signal to the controller 226. For example, the sensor 224 may include a light sensor configured to sense a brightness of the external environment 101 and provide a signal indicative of the brightness of the environment to the controller 226. The controller 226 may generate a control signal in response to the brightness signal, and the visual characteristic of the active layer 108 may change in response to the control signal. The sensor 224 may also include a microphone configured to sense a sound in the cabin or outside the vehicle and provide a signal indicative of the sound to the controller 226. For example, the sensor 224 may be configured to sense music being played through a sound system of the vehicle. The sensor 224 may also be configured to sense a sound of an emergency vehicle (e.g., an ambulance, police car, fire truck, etc.) near the vehicle 100. The controller 226 may generate a control signal in response to the sound signal, and the visual characteristic of the active layer 108 may change in response to the control signal. As another example, the sensor 224 may include a visible light camera directed toward an occupant and may be configured to sense a visual cue from the occupant, and the sensor 224 may provide a signal indicative of the visual cue of the occupant to the controller 226. The controller 226 may generate a control signal in response to the visual cue signal, and the visual characteristic of the active layer 108 may change in response to the control signal.

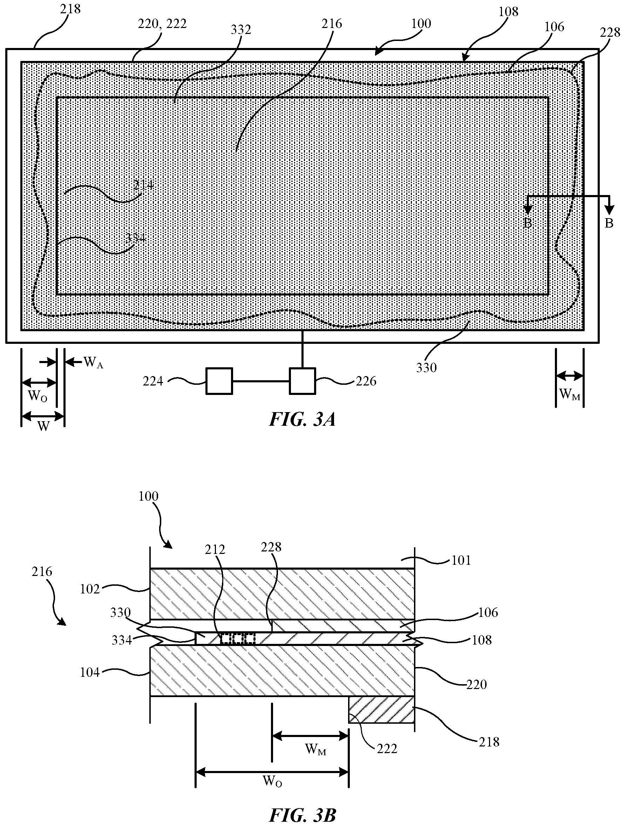

FIG. 3A is an illustration of the active layer 108 of the panel 100 of FIG. 1 and the mask layer 106. FIG. 3B is an illustration of a cross-section of a portion of the panel 100 of FIG. 3A taken across B-B. The mask layer 106 extends from the outer edge 220 toward the central portion 216 and is opaque. For example, the mask layer 106 may appear black when viewed along a viewing direction from inside the vehicle. The mask layer 106 extends between the outer edge 220 and the dotted line 228 that indicates the inner edge of the mask layer 106. For purposes of illustration of the relationship between the mask layer 106 and the active layer 108, only the inner edge of the mask layer 106 is shown (as indicated by the dotted line 228) in FIG. 3A. As shown, a width of the mask layer 106, indicated on FIG. 3 as W_{M}, extends between the outer edge 220 of the panel 100 and the dotted line 228 that indicates the inner edge of the mask layer 106. In some implementations, W_{M} is variable (e.g., W_{M} changes along the perimeter of the panel 100). As shown in FIG. 3B, in implementations where the inner edge 222 of the interior trim 218 overlaps the outer edge 220, W_{M} extends between the inner edge 222 of the interior trim 218 and the inner edge 228 of the mask layer 106 and W_{O} (a width of an opaque portion 330) extends between the inner edge 222 of the interior trim 218 and an inner edge 334 of the opaque portion 330. The active layer 108 is shown to include the opaque portion 330 and a transparent portion 332. The opaque portion 330 includes a group of the independently controllable active elements 212 that are configured to be in the opaque configuration (e.g., such that viewing the mask layer 106 is limited), and the transparent portion 332 includes a group of the independently controllable active elements 212 that are configured to be in the transparent configuration. Accordingly, the independently controllable active elements 212 that display a color (e.g., that are in the opaque configuration) are configured to limit viewing of the mask layer 106. The inner edge 214 of the transparent portion 332 is indicated by a dotted line for purposes of illustration. The interface between the transparent portion 332 and the central portion 216 is not visible. Though the above description described a relationship between the active layer 108 and the mask layer 106 (e.g., the active layer 108 obscuring a view of the mask layer 106), the above description may apply to a relationship between the active layer 108 and the adhesive layer that secures the panel 100 to the vehicle. In some implementations, the active layer 108 may obscure the adhesive layer in the same manner described with respect to the mask layer 106. Accordingly, the active layer 108 is configured to obscure the view of one or both of the adhesive layer and the mask layer 106.

As shown, the opaque portion 330 of the active layer 108 extends between the inner edge 222 of the interior trim 218 and an inner edge 334 of the opaque portion 330. In some implementations, the opaque portion 330 extends from the outer edge 220 of the panel to the inner edge 334 of the opaque portion 330. A width of the transparent portion 332 is indicated by W_{A}. Portions of the independently controllable active elements 212 are configured to change (e.g., in response to a control signal generated by the controller 226) between the transparent configuration and the opaque configuration to modify the width of the opaque portion 330 (W_{O}) of the active layer 108 relative to the width of the transparent portion 332 (W_{A}) of the active layer 108. For example, all of the independently controllable active elements 212 may be configured to be in the transparent configuration in response to a control signal from the controller 226. In such an embodiment, W_{O} would be zero and W_{A} would be the entire width of the active layer 108. In another example, all of the independently controllable active elements 212 may be configured to be in the opaque configuration in response to a control signal from the controller 226, where W_{A} would be zero and W_{O} would be the entire width of the active layer 108. In another example embodiment, a portion of the independently controllable active elements 212 may be configured to be in the transparent configuration, and a remainder of the independently controllable active elements 212 may be configured to be in the opaque configuration in response to a control signal from the controller 226. In such an embodiment, W_{O} corresponds to the portion of the independently controllable active elements 212 in the opaque configuration, and W_{A} corresponds to the remainder of the independently controllable active elements 212 in the transparent configuration. In general, the sum of W_{O} and W_{A} is the entire width of the active layer 108 (e.g., "W"). In some implementations, the width W_{O} that extends from the outer edge 220 of the panel 100 toward the central portion 216 may be approximately constant. For example, the value of W_{O} may be within plus or minus twenty-five percent of a stated measurement of W_{O}. In some implementations, the value of W_{O} may be within plus or minus twenty percent of the stated measurement of W_{O}. The value of W_{O} may also be within plus or minus fifteen percent of the stated measurement of Wo. In embodiments where the inner edge 222 overlaps the outer edge 220, the width W_{O} that extends between the inner edge 222 of the interior trim 218 and the inner edge 334 of the opaque portion 330 may be approximately constant. In some instances, the width W_{O} of the opaque portion 330 extends between the inner edge 222 of the interior trim 218 and the inner edge 334 of the opaque portion 330, and is approximately constant.

As described, the visual characteristic of the independently controllable active elements 212 is configured to change in response to a control signal from the controller 226. In some implementations, the visual characteristic is configured to change by modification of the width of the opaque portion 330 of the active layer 108 (e.g., W_{O}) that extends from the outer edge 220 of the panel 100. In some embodiments, the visual characteristic of the independently controllable active elements 212 includes an opacity, where the opacity of the independently controllable active elements 212 can range between a value of zero (e.g., transparent) and a value of one hundred (e.g., opaque). Independently controllable active elements 212 whose opacity values are between zero and one hundred would allow an occupant to partially see through the panel 100 and to see the color of the opaque portion 330. In some implementations, an opacity value of, for example, the first independently controllable active element 213a may be adjusted independently of, for example, the second independently controllable active element 213b. In such implementations, areas of the panel 100 that correspond to the first independently controllable active element 213a and the second independently controllable active element 213b may have different opacities. As a group, the independently controllable active elements 212 may display a visual characteristic of a band of color that is opaque near the outer edge 220 that gradually becomes more transparent as the band extends toward the central portion 216. Accordingly, the visual characteristic may be configured to change by a decrease of the opacity of the independently controllable active elements 212 as the active layer 108 extends toward the central portion 216 of the panel 100.

In addition, W_{O} may change in response to a signal from the sensor 224 related to the brightness of the external environment 101. For example, the sensor 224 may provide a signal to the controller 226 that indicates the external environment 101 is very bright (e.g., a sunny day, bright headlights approaching, etc.). In response, the controller 226 may generate a control signal, and W_{O} may increase (e.g., increase the size of the opaque portion 330) in response to the control signal to block some of the light from entering the vehicle. In contrast, the sensor 224 may provide a signal to the controller 226 that indicates the external environment 101 is not bright (e.g., a cloudy day, dusk, night time, traveling through a tunnel, etc.). In response, the controller 226 may generate a control signal, and W_{O} may decrease (e.g., decrease the size of the opaque portion 330) in response to the control signal to allow more light to enter the vehicle. Decreasing Wo may be accomplished, for example, by having a group of the independently controllable active elements 212 located closer to the central portion 216 be more transparent than another group of the independently controllable active elements 212 located further from the central portion 216 and closer to the inner edge 222. In some implementations, W_{O} is configured to change based on a threshold brightness value. In some instances, the threshold brightness value is absolute (e.g., does not depend on a previous brightness value). The threshold brightness value may also be a relative threshold value (e.g., the threshold value is based on a difference between a current brightness value and a previous brightness value). Accordingly, the size of the opaque portion 330 of the active layer 108 is configured to change in response to a signal indicating that the brightness of the external environment 101 is greater than (or less than) a threshold value.

Furthermore, W_{O} may change based on a visual cue from an occupant. For example, the sensor 224 may provide a signal to the controller 226 that indicates the occupant is squinting (e.g., due to brightness from the sun, approaching headlights, etc.). In response, the controller 226 may generate a control signal, and W_{O} may increase (e.g., increase the size of the opaque portion 330) in response to the control signal to block some of the light from entering the vehicle. In contrast, the sensor 224 may provide a signal to the controller 226 that indicates the occupant is not squinting (or has changed from squinting to not squinting). In response, the controller 226 may generate a control signal, and W_{O} may decrease (e.g., decrease the size of the opaque portion 330) in response to the control signal to allow more light to enter the vehicle. Accordingly, the size of the opaque portion 330 of the active layer 108 is configured to change in response to a signal indicating that the shape of the eye of the occupant indicates that the occupant is squinting.

In some embodiments, the controller 226 is configured to receive input from an occupant related to Wo. For example, an on-board computer coupled with the controller 226 may include a user interface that allows the occupant to indicate a desired adjustment to Wo. As another example, a user device (e.g., a mobile device such as a cellular phone, a tablet computer, etc.) may be coupled with the controller 226, and an occupant may indicate a desired adjustment to W_{O} via the user device. Accordingly, the size of the opaque portion 330 of the active layer 108 may be changed in response to input from the occupant.

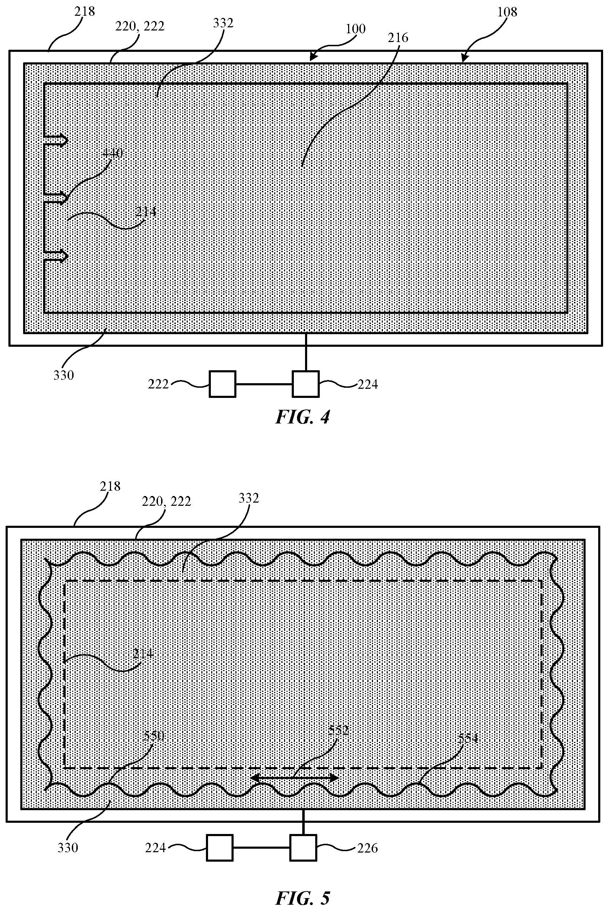

FIG. 4 is an illustration of the active layer 108 of the panel 100 of FIG. 1 in a first configuration. As shown, the opaque portion 330 includes a visual cue 440. The visual cue 440 is configured to notify the occupant of something of interest to the occupant. In some instances, the visual cue 440 is related to a road condition. The visual cue 440 may also be related to, for example, a nearby restaurant or venue the occupant likes, an incoming call or text on a mobile device associated with the occupant, etc. In the example where the visual cue 440 is related to a road condition, the sensor 224 may generate a signal that indicates there is a pothole on the left of the vehicle and provide the signal to the controller 226. The controller 226 may generate a control signal, and the independently controllable active elements 212 may be configured to generate the visual cue 440 in response to the control signal to notify the occupant of the upcoming pothole. For example, adjacent independently controllable active elements 212 (e.g., the first independently controllable active element 213a and the second independently controllable active element 213b) may have the same or different opacity levels to generate the visual cue 440. Additionally, adjacent independently controllable active elements 212 may have the same or different colors to generate the visual cue 440. Accordingly, the opaque portion 330 of the active layer 108 is configured to provide a visual cue to the occupant based on the road condition.

As shown in FIG. 4, the visual cue 440 may be an arrow. The visual cue 440 may also be any other type of visual indicator that would notify the occupant. For example, the visual cue 440 may include text that identifies the type of upcoming road condition (e.g., "there is a pothole upcoming on the left"), an image of the upcoming road condition, and other shapes such as a triangle, a trapezoid, etc., that may indicate a direction in which the occupant should maneuver the vehicle. In some instances, the visual cue 440 may be repeated along one or more sides of the active layer 108. The visual cue 440 may also include flashing or blinking (e.g., the portion of the independently controllable active elements 212 that are configured to generate the visual cue 440 are alternately configured to be in the opaque configuration and the transparent configuration). Furthermore, the visual cue 440 may be a different color than the remainder of the opaque portion 330 (e.g., the visual cue 440 may include a yellow color, and the remainder of the opaque portion 330 may include a black color).

FIG. 5 is an illustration of the active layer 108 of the panel 100 of FIG. 1 in an additional configuration. As shown, the opaque portion 330 has a curved edge 554. In some implementations, the opaque portion 330 may have multiple curved edges 554 that extend around a portion of the opaque portion 330. More specifically, a shape of the opaque portion 330 is configured to change (e.g., to include the curved edge 554, multiple curved edges 554, etc.) by modification of the shape of the opaque portion 330 in response to a sound. In some implementations, multiple curved edges 554 connect to each other and form an undulating portion 550. The undulating portion 550 is configured to move (e.g., in the direction of the arrow 552) in response to a sound within the cabin of the vehicle (e.g., the shape of the opaque portion 330 of the active layer 108 is configured to change in response to a sound). For example, the sensor 224 may generate a signal related to music that is playing in the cabin of the vehicle and provide the signal to the controller 226. The controller 226 may generate a control signal, and the independently controllable active elements 212 may be configured to generate the undulating portion 550 in response to the control signal such that the shape of the opaque portion 330 undulates in response to the sound. For example, adjacent independently controllable active elements 212 (e.g., the first independently controllable active element 213a and the second independently controllable active element 213b) may have the same or different opacity levels to generate the undulating portion 550. Additionally, adjacent independently controllable active elements 212 may have the same or different colors to generate the undulating portion 550. For example, the undulating portion 550 may look like waves that move with the beat of the music. The independently controllable active elements 212 may be configured to sequentially change between the transparent configuration and the opaque configuration to implement the undulating portion 550. Though the opaque portion 330 is shown in FIG. 5 as the undulating portion 550, various shapes of the opaque portion 330 can be achieved such that the illusion of motion of the opaque portion 330 is provided to the occupant.

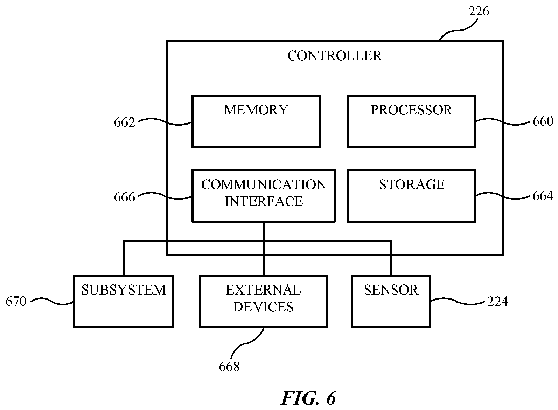

FIG. 6 is schematic diagram of the controller 226. The controller 226 may be used to implement the systems and methods disclosed herein. In some implementations, the controller 226 may be a separate controller, microprocessor, or microcontroller (e.g., not located in or on the vehicle), or may be implemented on the cloud. The controller 226 may also be part of an onboard vehicle controller. For example, the controller 226 may receive signals from the sensor 224 and control operation of the independently controllable active elements 212 in response to the signals. In an example hardware configuration, the controller 226 includes a processor 660, a memory 662, a storage 664, and a communication interface 666. Data and/or signals received from the sensor 224 may include signals related to a brightness of the external environment 101, upcoming road conditions, sounds from within the vehicle, etc. The processor 660 may be any suitable processor, such as a central processing unit, for executing computer instructions and performing operations described thereby. The memory 662 may be a volatile memory, such as random-access memory (RAM). The storage 664 may be a non-volatile storage device, such as a hard disk drive (HDD) or a solid-state drive (SSD). The storage 664 may form a computer readable medium that stores instructions (e.g., code) executed by the processor 660 for operating external devices 668 in the manners described above and below. The communication interface 666 is in communication with, for example, the external devices 668, the sensor 224, and a subsystem 670 for sending to and receiving from various signals (e.g., control signals and/or notifications). The external devices 668 may include, for example, systems or devices through which the occupant may provide information to the controller 226 for operation of the independently controllable active elements 212. For example, the external devices 668 may include devices such as a mobile device, a tablet computer, or other electronic devices that may communicate with the controller 226. Accordingly, the controller 226 may include an Internet connection to facilitate communication between the controller 226 and the external devices 668. The sensor 224 is configured to provide a signal to the controller 226, as described above. The subsystem 670 may include, for example, the panel 100. More specifically, the subsystem 670 may include the active layer 108 and the controller 226 may operate the active layer 108 based on the signal provided by the sensor 224.

As described above, implementations described herein include a panel of a vehicle that has an outer layer and an inner layer that is positioned closer to an interior surface of the vehicle than the outer layer. A mask layer is positioned between the outer layer and the inner layer. An active layer is positioned between the mask layer and the inner layer. The active layer is positioned adjacent to an outer edge of the panel and extends from the outer edge of the panel toward a central portion of the panel. The active layer includes a first independently controllable active element configured to limit viewing of the mask layer when viewed from a cabin of the vehicle.

In some implementations, the active layer includes a second independently controllable active element. The first independently controllable active element and the second independently controllable active element are configured to have a high transmissivity state and a low transmissivity state. The first independently controllable active element and the second independently controllable active element are configured to display a color when in the low transmissivity state.

In some implementations, the active layer includes an array of independently controllable active elements. The array of independently controllable active elements includes the first independently controllable active element and the second independently controllable active element. Each of the independently controllable active elements is configured to have a high transmissivity state and a low transmissivity state. The independently controllable active elements are configured to display a color when in the low transmissivity state.

In some implementations, the first independently controllable active element is configured to approximately match a color of an interior trim of the vehicle.

In some implementations, a portion of the array of independently controllable active elements is configured to change between the high transmissivity state and the low transmissivity state to adjust a width of an opaque portion of the active layer relative to a width of a transparent portion of the active layer. The opaque portion of the active layer may extend between an outer edge of the transparent portion and an inner edge of an interior trim of the vehicle. The width of the opaque portion that extends between the outer edge of the transparent portion and the inner edge of the interior trim of the vehicle is approximately constant.

In some implementations, a width of the mask layer that extends from the outer edge of the panel toward the central portion is variable, and a width of an opaque portion of the active layer that extends from the outer edge of the panel toward the central portion is approximately constant.

In some implementations, a width of the mask layer that extends from an inner edge of an interior trim of the vehicle toward the central portion of the vehicle is variable, and a width of an opaque portion of the active layer that extends from the inner edge of the interior trim of the vehicle toward the central portion of the vehicle is approximately constant.

Implementations described herein also include a panel of a vehicle that has an outer layer and an inner layer that is positioned closer to an interior surface of the vehicle than the outer layer. A mask layer is positioned between the outer layer and the inner layer. An active layer is positioned between the mask layer and the inner layer. The active layer may extend at least partially around a perimeter of the panel and from an outer edge of the panel toward a central portion of the panel. The active layer may include a first independently controllable active element that is configured to have an high transmissivity state and a low transmissivity state based on a signal received from a sensor.

In some implementations, the active layer includes a second independently controllable active element. The first independently controllable active element and the second independently controllable active element are configured to display a color when in the low transmissivity state. The first independently controllable active element may be configured to limit viewing of the mask layer when in the low transmissivity state.

In some implementations, the active layer includes an array of independently controllable active elements. The array of independently controllable active elements may include the first independently controllable active element and the second independently controllable active element.

In some implementations, a size of an opaque portion of the active layer is configured to change in response to the signal indicating that a shape of an eye of an occupant indicates that the occupant is squinting.

In some implementations, a size of an opaque portion of the active layer is configured to change in response to the signal indicating that a brightness of an external environment is greater than a threshold value.

In some implementations, a shape of an opaque portion of the active layer is configured to change in response to a sound.

In some implementations, an opaque portion of the active layer is configured to provide a visual cue to an occupant based on a road condition.

Implementations described herein also include a vehicle window for limiting viewing of a mask layer. The vehicle window includes a central portion through which an external environment can be viewed through the vehicle window. The vehicle window also includes an active layer that extends around a perimeter of the vehicle window and from an outer edge of the vehicle window toward the central portion. The active layer includes an array of independently controllable active elements having a visual characteristic configured to change in response to a signal.

In some implementations, the visual characteristic is configured to change by modification of a width of an opaque portion of the active layer that extends from the outer edge of the vehicle window. A size of the opaque portion of the active layer may also be configured to change in response to input from an occupant.

In some implementations, the visual characteristic is configured to change by a decrease of an opacity of the independently controllable active elements as the active layer extends toward the central portion of the vehicle window

In some implementations, the visual characteristic is configured to change by modification of a shape of an opaque portion of the active layer in response to a sound to change the visual characteristic. The visual characteristic may be configured to change by undulation of the shape of the opaque portion in response to the sound.

As described above, one aspect of the present technology is the gathering and use of data available from various sources for use during operation of the active layer 108. As an example, such data may identify the user and include user-specific settings or preferences. The present disclosure contemplates that in some instances, this gathered data may include personal information data that uniquely identifies or can be used to contact or locate a specific person. Such personal information data can include demographic data, location-based data, telephone numbers, email addresses, twitter ID's, home addresses, data or records relating to a user's health or level of fitness (e.g., vital signs measurements, medication information, exercise information), date of birth, or any other identifying or personal information.

The present disclosure recognizes that the use of such personal information data, in the present technology, can be used to the benefit of users. For example, a user profile may be established that stores user preference related information that allows adjustment of the active layer 108 according to the user preferences. Accordingly, use of such personal information data enhances the user's experience.

The present disclosure contemplates that the entities responsible for the collection, analysis, disclosure, transfer, storage, or other use of such personal information data will comply with well-established privacy policies and/or privacy practices. In particular, such entities should implement and consistently use privacy policies and practices that are generally recognized as meeting or exceeding industry or governmental requirements for maintaining personal information data private and secure. Such policies should be easily accessible by users, and should be updated as the collection and/or use of data changes. Personal information from users should be collected for legitimate and reasonable uses of the entity and not shared or sold outside of those legitimate uses. Further, such collection/sharing should occur after receiving the informed consent of the users. Additionally, such entities should consider taking any needed steps for safeguarding and securing access to such personal information data and ensuring that others with access to the personal information data adhere to their privacy policies and procedures. Further, such entities can subject themselves to evaluation by third parties to certify their adherence to widely accepted privacy policies and practices. In addition, policies and practices should be adapted for the particular types of personal information data being collected and/or accessed and adapted to applicable laws and standards, including jurisdiction-specific considerations. For instance, in the US, collection of or access to certain health data may be governed by federal and/or state laws, such as the Health Insurance Portability and Accountability Act (HIPAA); whereas health data in other countries may be subject to other regulations and policies and should be handled accordingly. Hence different privacy practices should be maintained for different personal data types in each country.

Despite the foregoing, the present disclosure also contemplates embodiments in which users selectively block the use of, or access to, personal information data. That is, the present disclosure contemplates that hardware and/or software elements can be provided to prevent or block access to such personal information data. For example, in the case of storing a user profile for operating the active layer 108, the present technology can be configured to allow users to select to "opt in" or "opt out" of participation in the collection of personal information data during registration for services or anytime thereafter. In another example, users can select not to provide data regarding usage of specific applications. In yet another example, users can select to limit the length of time that application usage data is maintained or entirely prohibit the development of an application usage profile. In addition to providing "opt in" and "opt out" options, the present disclosure contemplates providing notifications relating to the access or use of personal information. For instance, a user may be notified upon downloading an app that their personal information data will be accessed and then reminded again just before personal information data is accessed by the app.

Moreover, it is the intent of the present disclosure that personal information data should be managed and handled in a way to minimize risks of unintentional or unauthorized access or use. Risk can be minimized by limiting the collection of data and deleting data once it is no longer needed. In addition, and when applicable, including in certain health related applications, data de-identification can be used to protect a user's privacy. De-identification may be facilitated, when appropriate, by removing specific identifiers (e.g., date of birth, etc.), controlling the amount or specificity of data stored (e.g., collecting location data at a city level rather than at an address level), controlling how data is stored (e.g., aggregating data across users), and/or other methods.
Therefore, although the present disclosure broadly covers use of personal information data to implement one or more various disclosed embodiments, the present disclosure also contemplates that the various embodiments can also be implemented without the need for accessing such personal information data. That is, the various embodiments of the present technology are not rendered inoperable due to the lack of all or a portion of such personal information data. For example, user preference information may be determined each time the active layer 108 is used, such as by entering user preference information in real time, and without subsequently storing the information or associating with the particular user.

### NUMBERED STATEMENTS OF THE INVENTION

1. A panel of a vehicle, comprising:
   an outer layer;
   an inner layer that is positioned closer to an interior surface of the vehicle than the outer layer;
   a mask layer positioned between the outer layer and the inner layer; and
   an active layer positioned between the mask layer and the inner layer, the active layer positioned adjacent to an outer edge of the panel and extending from the outer edge of the panel toward a central portion of the panel, wherein the active layer includes an array of independently controllable active elements configured to limit viewing of the mask layer when viewed from a cabin of the vehicle.
2. The panel of statement 1, wherein each of the independently controllable active elements is configured to have an approximately transparent configuration and an opaque configuration in which each of the independently controllable active elements is configured to display a color.
3. The panel of statement 2, wherein the color approximately matches an interior trim of the vehicle.
4. The panel of statement 2, wherein a portion of the independently controllable active elements is configured to change between the approximately transparent configuration and the opaque configuration to adjust a width of an opaque portion of the active layer relative to a width of an approximately transparent portion of the active layer, wherein the opaque portion of the active layer extends between an outer edge of the approximately transparent portion and an inner edge of an interior trim of the vehicle.
5. The panel of statement 4, wherein the width of the opaque portion that extends between the outer edge of the approximately transparent portion and the inner edge of the interior trim of the vehicle is approximately constant.
6. The panel of statement 1, wherein a width of the mask layer that extends from the outer edge of the panel toward the central portion is variable, and a width of an opaque portion of the active layer that extends from the outer edge of the panel toward the central portion is approximately constant.
7. The panel of statement 1, wherein a width of the mask layer that extends from an inner edge of an interior trim of the vehicle toward the central portion of the vehicle is variable, and a width of an opaque portion of the active layer that extends from the inner edge of the interior trim of the vehicle toward the central portion of the vehicle is approximately constant.
8. A panel of a vehicle, comprising:
   an outer layer;
   an inner layer that is positioned closer to an interior surface of the vehicle than the outer layer;
   a mask layer positioned between the outer layer and the inner layer; and
   an active layer positioned between the mask layer and the inner layer, the active layer extending at least partially around a perimeter of the panel and from an outer edge of the panel toward a central portion of the panel, wherein the active layer includes an array of independently controllable active elements, and each of the independently controllable active elements is configured to have an approximately transparent configuration and an opaque configuration based on a signal received from a sensor.
9. The panel of statement 8, wherein the independently controllable active elements are each configured to display a color when in the opaque configuration.
10. The panel of statement 9, wherein the independently controllable active elements that display a color are configured to limit viewing of the mask layer.
11. The panel of statement 8, wherein a size of an opaque portion of the active layer is configured to change in response to the signal indicating that a shape of an eye of an occupant indicates that the occupant is squinting.
12. The panel of statement 8, wherein a size of an opaque portion of the active layer is configured to change in response to the signal indicating that a brightness of an external environment is greater than a threshold value.
13. The panel of statement 8, wherein a shape of an opaque portion of the active layer is configured to change in response to a sound.
14. The panel of statement 8, wherein an opaque portion of the active layer is configured to provide a visual cue to an occupant based on a road condition.
15. A vehicle window for limiting viewing of a mask layer, comprising:
   a central portion through which an external environment can be viewed through the vehicle window; and
   an active layer that extends around a perimeter of the vehicle window and from an outer edge of the vehicle window toward the central portion and includes an array of independently controllable active elements having a visual characteristic configured to be controlled in response to a signal.
16. The vehicle window of statement 15, wherein the visual characteristic is controlled by changing a width of an opaque portion of the active layer that extends from the outer edge of the vehicle window.
17. The vehicle window of statement 16, wherein a size of the opaque portion of the active layer is changed in response to input from an occupant.
18. The vehicle window of statement 15, wherein the visual characteristic is controlled by decreasing an opacity of the independently controllable active elements as the active layer extends toward the central portion of the vehicle window.
19. The vehicle window of statement 15, wherein the visual characteristic is controlled by causing a shape of an opaque portion of the active layer to change in response to a sound.
20. The vehicle window of statement 19, wherein the shape of the opaque portion undulates in response to the sound.

## Claims

1. A panel of a vehicle, comprising:
an outer layer;
an inner layer that is positioned closer to an interior surface of the vehicle than the outer layer;
a mask layer positioned between the outer layer and the inner layer; and
an active layer positioned between the mask layer and the inner layer, the active layer positioned adjacent to an outer edge of the panel and extending from the outer edge of the panel toward a central portion of the panel, wherein the active layer includes a first independently controllable active element configured to limit viewing of the mask layer when viewed from a cabin of the vehicle.

2. The panel of claim 1, wherein the active layer includes a second independently controllable active element, wherein the first independently controllable active element and the second independently controllable active element are configured to have a high transmissivity state and a low transmissivity state, wherein the first independently controllable active element and the second independently controllable active element are configured to display a color when in the low transmissivity state.

3. The panel of claim 1, wherein the active layer includes an array of independently controllable active elements, wherein the array of independently controllable active elements includes the first independently controllable active element and the second independently controllable active element, wherein each of the independently controllable active elements is configured to have a high transmissivity state and a low transmissivity state, wherein the independently controllable active elements are configured to display a color when in the low transmissivity state.

4. The panel of claim 3, wherein the first independently controllable active element is configured to approximately match a color of an interior trim of the vehicle.

5. The panel of claim 3 or 4, wherein a portion of the array of independently controllable active elements is configured to change between the high transmissivity state and the low transmissivity state to adjust a width of an opaque portion of the active layer relative to a width of a transparent portion of the active layer, wherein the opaque portion of the active layer extends between an outer edge of the transparent portion and an inner edge of an interior trim of the vehicle.

6. The panel of claim 5, wherein the width of the opaque portion that extends between the outer edge of the transparent portion and the inner edge of the interior trim of the vehicle is approximately constant.

7. The panel of claim 5, wherein the width of the opaque portion of the active layer is configured to change in response to a signal indicating that a shape of an eye of an occupant indicates that the occupant is squinting.

8. The panel of claim 5 or 7, wherein the width of the opaque portion of the active layer is configured to change in response to a signal indicating that a brightness of an external environment is greater than a threshold value.

9. The panel of claim 5, 7 or 8 wherein a shape of the opaque portion of the active layer is configured to change in response to a sound.

10. The panel of claim 9, wherein the shape of the opaque portion of the active layer is configured to change by undulation of the shape of the opaque portion in response to the sound.

11. The panel of any of claims 5 to 10, wherein the opaque portion of the active layer is configured to provide a visual cue to an occupant based on a road condition.

12. The panel of claim 11, wherein the visual cue indicates a direction in which to maneuver the vehicle.

13. The panel of claim 5 or any of claims 7 to 12 wherein the width of the opaque portion of the active layer is configured to change in response to input from an occupant.

14. The panel of any of claims 1 to 4, wherein a width of the mask layer that extends from the outer edge of the panel toward the central portion is variable, and a width of an opaque portion of the active layer that extends from the outer edge of the panel toward the central portion is approximately constant.

15. The panel of any of claims 1 to 4, wherein a width of the mask layer that extends from an inner edge of an interior trim of the vehicle toward a central portion of the vehicle is variable, and a width of an opaque portion of the active layer that extends from the inner edge of the interior trim of the vehicle toward the central portion of the vehicle is approximately constant.
